# EUROPÄISCHE PATENTSCHRIFT

(11) **EP 0 743 528 B1**
(45) Veröffentlichungstag und Bekanntmachung des Hinweises auf die Patenterteilung: **28.09.2005**
(21) Anmeldenummer: 96102159.9
(22) Anmeldetag: 14.02.1996
(51) Int. Cl.: G01R 31/00, G01R 15/04

(54) **Vorrichtung zum Messen der Netzspannung für Schienenfahrzeuge**
Mains voltage measuring appliance for track vehicles
Dispositif pour mesurer la tension de réseau pour véhicule de chemin de fer

(30) Priorität: 19.05.1995 IT MI951029
(43) Veröffentlichungstag der Anmeldung: 20.11.1996
(73) Patentinhaber: MICROELETTRICA SCIENTIFICA S.p.A., I-20089 Rozzano (Milano) (IT)
(72) Erfinder: Dossena, Giovanna, I-26013 Crema (IT); Ardemagni, Pierenrico, I-20075 Lodi (IT)
(74) Vertreter: Mayer, Hans Benno

(56) Entgegenhaltungen:
- EP-A- 0 010 151
- DE-A- 2 333 907
- ABB REVIEW, Nr. 4, 1.Januar 1993, Seiten 9-14, XP000368143 "INNOVATIVE DUAL-SYSTEM LIGHT RAIL VEHICLES FOR 15 KV, 16 2/3 HZ AND 750 VDC TAKING THE 'TRAM' ON DB TRACK"
- ELEKTRISCHE BAHNEN, Bd. 89, Nr. 10, 1.Oktober 1991, Seiten 299-308, XP000230599 LEICHTFRIED H ET AL: "DIE BRENNERLOKOMOTIVE BAUREIHE 1822"

## Beschreibung

Die vorstehende Erfindung betrifft eine Vorrichtung zum Messen der zugeführten elektrischen Netzspannung oder der Betriebsspannung für Schienenfahrzeuge, besonders für Lokomotiven, die mit Mehrfachspannung antreibbar sind, d.h. Lokomotiven, denen verschiedene Spannungswerte sowohl in Form einer Gleichstromspannung als auch in Form einer Wechselstromspannung zuführbar sind.

Die elektrifizierten Schienennetze sehen zur Zeit Schienenstrecken vor, die mit unterschiedlichen Betriebsspannungen versorgt werden, dies ist nicht nur der Fall zwischen verschiedenen Staaten, sondern auch im Inneren des Betriebsnetzes eines nationalen Eisenbahnnetzes selbst. An den Endpunkten zwischen zwei Strecken, die mit unterschiedlicher Spannung betrieben werden, ist ein kurzes Streckennetz von ca. 50 m vorgesehen, das von der Lokomotive mit abgesenktem Stromabnahmetaster durchfahren wird. In diesem Zwischenstück der Schienenstrecke ist die Versorgungsleitung isoliert und auch die Gleise sind über Isolierstücke mit dem Rest des Schienenstranges verbunden.

Üblicherweise sind Lokomotiven, die mit Mehrfachspannung betrieben werden können, in der Lage, unter Zuführung folgender Betriebsspannungen, die im europäischen Schienennetz üblich sind, zu arbeiten.
(A) 1.500 V Gleichstrom
(B) 3.000 V Gleichstrom
(C) 15.000 V Wechselstrom (Frequenz 16,6 Hz)
(D) 25.000 V Wechselstrom (Frequenz 50 Hz).

Eine Lokomotive, die mit Mehrfachspannung betrieben wird, ist mit einer Einrichtung ausgerüstet, die bei Einfahren in einen neuen Streckenabschnitt die Spannung über den Stromaufnahmetaster erhält, dabei den Wert der Betriebsspannung erkennt und diese Information an eine Kontrolleinrichtung weiterleitet, welche dafür sorgt, daß der Motor für einen Betrieb mit dem neuen Spannungswert geschaltet wird.

Die bekannten Einrichtungen dieser Art weisen einen Sensor auf, der einen Reduktionstransformator aufweist, von dem ein Ende der Primärwicklung mit dem Stromaufnahmetaster verbunden ist und das andere Ende über eine Entladeeinrichtung an Masse gelegt ist.

Ein proportionales Signal für die Betriebsspannung in Form eines Wechselstromes (Fall C und D) ist an den Enden der Sekundärwicklung vorhanden, wobei im Fall einer Gleichstromspannung (Fall A und B) ein proportionales Signal an den Enden der Entladeeinrichtung ansteht.

Die bekannten Einrichtungen dieser Art weisen ein erhebliches Gewicht und erhebliche Fertigungskosten auf, sowohl für die einzelnen Bauteile als auch für die Inbetriebnahme der Einrichtung; diese Kosten sind nicht vernachlässigbar.

Ferner wird durch den als Transformator ausgebildeten Sensor eine Isolierung bei Wechselstrom sichergestellt, die Einrichtung ist aber nicht elektrisch isoliert bei Vorliegen einer Gleichstromspannung. Bei Auftreten einer Störung besteht demzufolge keine Gewißheit, daß die unter Hochspannung stehenden Schaltkreise gegenüber den auf Niederspannung ausgelegten Bauteilen isoliert sind.

Ferner ergibt sich bei den bekannten Vorrichtungen die Notwendigkeit, die Netzspannung (Wechselstrom/Gleichstrom) vor Weiterleitung eines Signales an den Antriebsschaltkreis festzulegen.

EP-A-O 010 151 beschreibt einen Schaltkreis für die Diskriminierung von hohen Spannungen, sowohl in Form von Gleichspannungen als auch Wechselspannungen, mit unterschiedlicher Amplitude, dies unter Verwendung einer optischen Kopplungseinrichtung, um damit die Vorrichtung elektrisch gegenüber hohen Spannungen zu isolieren.

ABB Review, Nr. 4, Januar 1993, Seiten 9-14, sowie Elektrische Bahnen, Band 89, Nr. 10, Oktober 1991, Seiten 299-308 beschreiben den Einsatz eines Transformators zum Messen einer Wechselspannung, sowie einen Sensor zum Messen einer Gleichspannung.

DE 2333907 beschreibt eine Vorrichtung, insbesondere einen Sensor zum Messen einer Gleichspannung bis 4000 Volt, wobei eine dem Gleichstrom-Messwert proportionale Umsetzung in eine impulsbreite oder frequenzmodulierte elektrische Wechselgrösse erfolgt und, dass diese Wechselgrösse einen optischen Koppler steuert, der mit einem Ausgabeintegrator verbunden ist.

Aufgabe der vorstehenden Erfindung ist es, eine Messvorrichtung zu schaffen, mit der es möglich ist, die Nachteile des Standes der Technik zu vermeiden, und besonders die Möglichkeit zu eröffnen, eine galvanische - Trennung sowohl für Wechselstrom als auch für Gleichstrom zu verwirklichen. In vorteilhafter Weise weist die erfindungsgemäße Vorrichtung ein vermindetes Gewicht auf und kann mit verminderten Kosten hergestellt werden und führt ferner zu einer Zusammenlegung der Hilfsfunktionen, wobei ein Effektivwert sowie ein direkter Proportionalausgang für das Messsignal geschaffen wird, ohne dass eine Umschaltung erforderlich sei.

Die erfindungsgemäße Vorrichtung ist ferner in der Lage, den Spannungswert automatisch zu erkennen, ohne dass hierzu ein direkter Eingriff eines Bedienungsmannes notwendig wird. Dies stellt einen wesentlichen Vorteil zum Beispiel dann dar, wenn die geographischen Grenzen eines Staates nicht genau festgelegt oder genau erkennbar sind.
Die vorgenannte Aufgabe wird mit einer Vorrichtung nach Patentanspruch 1 gelöst.

Eine solche Vorrichtung weist maximale Sicherheit für die Bedienungspersonen des Fahrzeuges sowie für die Fahrgäste auf, da die Einrichtungen und deren Bauteile, die bei Auftreten einer Störung unter Spannung stehen könnten, in einem abgedichteten Metallgehäuse angeordnet sind, das eine hohe galvanische Trennung darstellt.

Die erfindungsgemäße Vorrichtung führt folgende Funktionen durch:
- Messen und Übertragung in einer Spannungsschleife (4 bis 20 mA oder 0 bis 100 mA der Arbeitsspannung (oder über eine Serienleitung)
- Messen des effektiven Wertes (r.m.s.) und Übertragung in einer Stromschleife der Arbeitsspannung (oder in einer Serienleitung)
- Festlegen des Funktionsintervalles der Arbeitsspannung (A, B, C, D);
- Funktionstest bei abgesenktem Stromabnehmer und der dazugehörenden Schutzeinrichtungen;
- Diagnose der Funktionsblöcke, die die Einrichtung in ihrer Gesamtheit darstellen.

Weitere Vorteile und Merkmale sind Gegenstand der Unteransprüche.

Die Erfindung wird nun genauer unter Bezugnahme auf die beigefügten Zeichnungen beschrieben.

Die Zeichnungen stellen ein bevorzugtes Ausführungsbeispiel der Erfindung dar. Es zeigen:
Fig. 1 schematisch eine mit Mehrfachspannung betriebene Lokomotive, die mit der erfindungsgemäßen Einrichtung ausgerüstet ist.
Fig. 2 ein Blockschaltbild, das den Aufbau der erfindungsgemäßen Vorrichtung darstellt, und
Fig. 3 den äußeren Aufbau der Meßeinrichtung (POD).

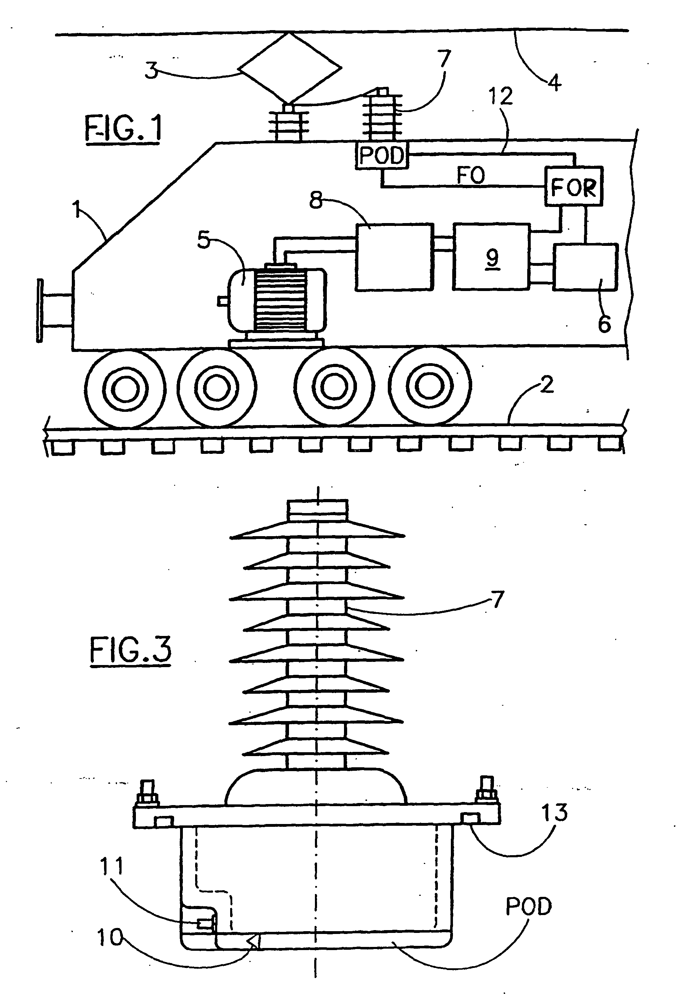

Fig. 1 zeigt schematisch eine Lokomotive 1, die mit Mehrfachspannung angetrieben wird. Die Lokomotive ist auf Schienen 2 verfahrbar und von einem Elektromotor 5 angetrieben. Dieser Motor wird mit elektrischer Energie über die Leitung 4 (Oberleitung) durch einen Stromabnehmer 3 betrieben. Der Motor 5 wird über eine Kontrolleinrichtung 8 gespeist, eine Kontrolleinrichtung 8 ist mit einer Synchronisiervorrichtung 9 verbunden, die ihrerseits mit einer Kontroll- und Steuerschaltung 6 verbunden ist.

Die erfindungsgemäße Vorrichtung weist zwei Betriebseinheiten auf, d.h. eine Meßeinheit POD, die auf dem Dach des Fahrzeuges montiert ist, und eine Schnittstelle FOR, die im Inneren der Lokomotive vorgesehen ist.

Die zwei Einheiten sind untereinander durch ein Zuführleitung 12 und ein optisches Fiberkabel FO verbunden.

Die POD-Einheit ist an die Spannung angeschlossen, die am Stromabnehmer 3 anliegt, und stellt die Meßgröße dar. Die Einheit POD ist als dichte Baueinheit ausgebildet und in der Nähe des Abnehmergestänges vorgesehen, wie dies deutlicher in Fig. 3 dargestellt ist.

Die Einheit FOR (Niederspannung) ist in der Nähe einer Kontrolleinrichtung 6 der Lokokmotive angeordnet und stellt die Schnittstelle nach außen dar, besonders zu den Antriebseinrichtungen und den Anzeige- und Steuerrvorrichtungen der Lokomotive.

Die Einheit POD ist in der Lage, das Vorhandensein eines Gleichstromes oder eines Wechselstromes festzustellen und somit das Skalenende (s.f.) zum Ablesen und zum Filtern wie folgt anzupassen.

| Gleichspannung | Wechselspannung |
|---|---|
| f.s. = 5.000 V | f.s. = 50.000 V |
| | (Spitzenspannung) |
| durchlaufende Frequenz | durchlaufende Frequenz |
| 90 Hz | 20 kHz |

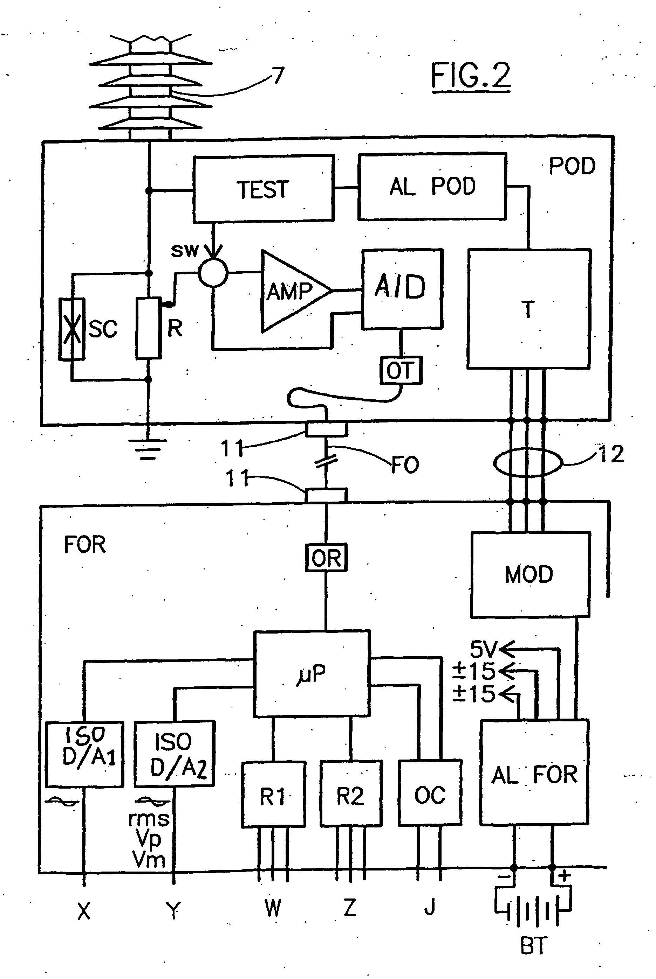

Unter besonderer Bezugnahme auf Fig. 2 sieht die Einheit POD einen als Widerstand ausgebildeten Spannugsteiler R mit erhöhten Werten vor, der durch den Widerstand in Fig. 2 dargestellt ist, und zwischen dem Stromabnehmer 3 und Masse angeordnet ist, wodurch die vom Stromabnehmer abgenommene Spannung geteilt wird und der Spannungswert auf Werte eingestellt wird, die für die Bauteile der Schaltung akzeptabel sind. Ein Spannungsableiter SC schützt den Meßeingang gegen eventuell auftretende Überspannungen oder der Beschädigung des als Widerstand ausgebildeten Spannungsteilers, z.B. bei einem Strom gegen Masse von 34 kA für 20 µs.

Der als Widerstand ausgebildete Spannungsteiler R ist mit einer Verstärker AMP über einen Schalter SW verbunden und dies ermöglicht es, die Spannung des als Widerstand ausgebildeten Spannungsteiler R dem Verstärker AMP zuzuführen oder direkt einem Umschaltglied A/D, das überträgt.

Der Schalter wird von einem Schaltkreis betätigt, der das Vorhandensein eines Gleichspannungssignales oder Wechselstromsignales erkennt. Bei Vorliegen eines Gleichstromsignales wird die abgenommene Spannung von dem als Widerstand ausgebildeten Spannungsteiler R verstärkt und anschließend einem Wandler A/D zugeführt. Bei Vorliegen eines Wechselstromsignales wird die Spannung direkt an den Wandler A/D angelegt.

Diese Auswahl gewährleistet die Genauigkeit der Messungen auch an der untersten Seite der Skala (1 kV). Ein z.B. als optisch-elektrischer Transduktor oder optisches Übertragungsglied OT ausgebildetes Bauteil liefert an seinem Ausgang ein optisches Signal für das Glasfaserkabel, z.B. an einem Stecker 11 für Glasfaserkabel, wie einem Stecker des Typs ST.

Die Einheit POD beinhaltet ferner eine Testsschaltung, die es erlaubt, die Funktionsfähigkeit des Ableiters für den praktischen Fall zu prüfen.

Die Einheit POD sieht ferner eine innere Speiseeinrichtung ALPOD vor, die mit einem Entkopplungstransformator T verbunden ist. Der Entkopplungstransformator T ist bis 70 kV isoliert und in einem Gehäuse untergebracht und wird über die Einheit FOR eingespeist, wie im folgenden noch genauer dargestellt.

Die Einheit POD führt über den Wandler A/D die Erkennung und die Umwandlung analog/digital des Signales durch, das dem als Widerstand ausgebildeten Spannungsteiler R angeliefert wird. Die Erkennung erfolgt mit einer Frequenz von 40 kHz und zur Kodifizierung werden 12 Bit verwendet, mit Werten am Ende der Skala und am Anfang der Skala, die auf 50 kV - 1 kV Gleichstrom festgelegt sind. Der Verstärker AMB führt einen Multiplikationsfaktor 10 ein, um wenigstens 10 betriebswesentliche Bits zu wandeln, auch wenn Gleichstrom vorliegt.

Im Anschluß wird nun die Einheit FOR genauer beschrieben.

Diese Einheit FOR erfüllt eine Doppelfunktion, d.h. sie hat Einspeisefunktion und Verarbeitungsfunktion. Die Einheit weist eine Einspeiseeinrichtung ALFOR auf, die mit der Bordbatterie BT verbunden ist, welche einen elektrischen Strom von 24 V Gleichstrom liefert, und am Ausgang Spannungen liefert, die alle untereinander isoliert sind und für die Betätigung der gesamten Vorrichtung notwendig sind.
1. +5 V für digitale Schaltungen
2. ±15 V für den Analogausgang r.m.s.
3. ±15 V für direkten Analogausgang
4. +5 V für die Speisung der Einheit POD.

Diese letztere Spannung wird einem Modulator MOD zugeführt und von diesem über ein Kabel 12 mit drei Leitern dem Entkopplungstransformator T der Einheit POD zugeführt.

Die Baugruppe der Schnittstelle FOR, die für die Bearbeitung des Signales verantwortlich ist, welches vom optischen Faserkabel angeliefert wird, weist einen Stecker 11 für ein optisches Faserkabel auf, einen optisch-elektrischen Transduktor oder einen optischen Empfänger OR, einen Mikroprozessor µP und zwei Wandler, digital/analog. Ein Wandler ist direkt mit dem Empfänger OR verbunden, während der andere Wandler vom Mikroprozessor µP gesteuert wird.

Die Ausgänge der zwei Wandler sind einem direkten Analogausgang X und einem Analogausgang Y des effektiven Wertes (mittlerer Quadratwert oder r.m.s.) verbunden.

Mit dem Mikroprozessor µP sind ferner zwei Relais R1, R2, OC verbunden, deren Ausgänge mit den Ausgängen W und Z verbunden sind.

Die Arbeitsweise der Schnittstelle FOR ist folgende:

Die Einheit erhält das Digitalsignal und speichert es unter Zuhilfenahme des Mikroprozessors µP ab, anschließend wird der Wert r.m.s. berechnet und der errechnete Wert in digitalisierter Form an den Wandler ISO D/A2 weitergeleitet. Das digitale Eingangssignal wird dem Wandler ISO A/D1 zugeführt, der den direkten Ausgang X überwacht. Wenn das Signal als Gleichstrom ansteht, so errechnet der Mikroprozessor µP den Mittelwert und mit den gleichen Modalitäten wird der Wert am Analogausgang zur Verfügung gestellt. Sofern das Signal als Wechselstrom vorliegt, berechnet der Mikroprozessor den Effektivwert oder r.m.s. (Integral des Quadrates der Meßwerte) und, unter Verwendung des Wandlers ISO D/A2, wird das Signal am Analogausgang Y (von r.m.s.) zur Verfügung gestellt und durch die Kontrolleinrichtung weiterverwendet.

Die Digitalausgänge sind von den zwei Stadien der Relais R1 und R2 (elektromechanische Ausführung oder solid state) unter der Kontrolle des Mikroprozessors µP gebildet und kodifizieren entsprechend einer redundanten Logik die Information bezüglich der Art der Arbeitsspannung innerhalb der vorgesehenen Grenzwerte (Felder A, B, C, D).

Die Redundanz erlaubt es, die Funktion fehlerfrei auch bei gestörtem Arbeiten von einem der Relais zu garantieren. Im Fall des dargestellten Ausführungsbeispieles, unter Verwendung von elektromechanischen Relais, sind diese mit einem Ausgangskontakt des Typs NA (normalerweise geöffnet) ausgerüstet. Die Schnittstelle FOR beinhaltet einen optischen Koppler OC, der es ermöglicht, das Testsignal aufzunehmen und an POD (TEST des Ableiters) weiterzusenden.

Die Funktionsblöcke ISO D/A1, ISO D/A2, R1, R2 können durch eine oder zwei Serienleitungen RS 232 oder RS 485 ersetzt werden und diese Serienleitungen übertragen als Code die gleichen Informationen, d.h. den Momentanwert der Spannung, den Momentanwert r.m.s., die Art A, B, C, D.

Unter Betrachtung der Figur 3 wird ersichtlich, daß die Einheit POD, die dazu dient, die Spannung des Stromabnehmers herabzusenken und zu messen, in einem Metallgehäuse 10 untergebracht ist, das einen Flansch 13 aufweist, der mit einer Dichtung versehen ist, und einem Anschluß 11 für ein optisches Fiberkabel FO, welches in einer Ausnehmung des Behälters vorgesehen ist, während ein Stecker für das Zuführleitung 12 in einer ähnlichen Ausnehmung (nicht dargestellt) vorgesehen ist.

Der als Widerstand ausgebildete Spannungsteiler R, der aus geeignetem Isoliermaterial hergestellt ist, z.B. aus Silikongummi oder zykloaliphatischem Harz, stellt den Meßsensor zur voltmetrischen Messung dar, und ist direkt mit der Spannung des Stromabnehmers gekoppelt.

Die Erfindung wurde unter Bezugnahme auf eine besondere Ausführungsform beschrieben, die Beschreibung soll aber nicht als einschränkend angesehen werden und bezieht sich auch auf Varianten und Ausführungsbeispiele, die für einen Fachmann naheliegend sind.

Selbstverständlich könnte die Vorrichtung auch in einem einzigen Gehäuse untergebracht werden, Gehäuse, das z.B. auf dem Dach der Lokomotive angeordnet ist.

## Patentansprüche

1. Vorrichtung zum Messen der Netzspannung in einem Schienenfahrzeug (1), mit einem Sensor (7) zum Erfassen der Spannung, wobei der Sensor (7) mit dem Stromabnehmer (3) des Schienenfahrzeugs verbindbar ist, und mit einer Auswerteschaltung (6), wobei diese Auswerteschaltung (6) auf der einen Seite mit dem Sensor (7) und auf der anderen Seite mit einer Kontrolleinrichtung (8) des Elektromotors (5) des Schienenfahrzeugs (1) verbindbar ist, **dadurch gekennzeichnet, dass**
die Vorrichtung eine Messeinrichtung (POD) aufweist, welche Messeinrichtung (POD) einen als Widerstand ausgebildeten Spannungsteiler (R) und einen Entkopplungstransformator (T) aufnimmt, und dass
die Vorrichtung weiterhin eine Schnittstelle (FOR) aufweist,
wobei die Messeinrichtung (POD) und die Schnittstelle (FOR) miteinander über eine Zuführleitung (12), die mit dem Entkopplungstransformator (T) verbunden ist, sowie über ein optisches Fiberkabel (FO) verbunden sind.

2. Vorrichtung, nach Patentanspruch 1, **dadurch gekennzeichnet, dass** die Messeinrichtung (POD) einen Verstärker (AMP) aufweist, der mit dem als Widerstand ausgebildeten Spannungsteiler (R) verbunden ist, mit einem Wandler (A/D), das die direkt vom als Widerstand ausgebildeten Spannungsteiler (R) oder vom Verstärker (AMP) erhaltene Information aufzeigt und in digitale Form umwandelt, mit einem Schaltkreis (TEST), der die Probespannung eines Entladers (SC) liefert, der zwischen dem als Widerstand ausgebildeten Spannungsteiler (R) und der Masse anliegt, um den Messeingang zu schützen, sowie mit einem elektro-optischen Transduktor (OT), der am Ausgang ein optisches Signal zur Verfügung stellt, das dem Fiberkabel (FO) zugeleitet wird.

3. Vorrichtung, nach Patentanspruch 2, **dadurch gekennzeichnet, dass**
die Messeinrichtung (POD) eine innenliegende Einspeiseeinrichtung (ALPOD) aufweist, die über den Entkopplungstransformator (T) und die an dessen Ausgang angeschlossene Zuführleitung (12) der Schnittstelle (FOR) zugeordnet ist.

4. Vorrichtung, nach Patentanspruch 1 bis 3, **dadurch gekennzeichnet, dass** die Schnittstelle (FOR) einen optisch-elektrischen Transduktor (OR), einen Mikroprozessor (µP), der mit dem optisch-elektrischen Transduktor (OR) gekoppelt ist, einen ersten Digital-Analog-Wandler (ISO D/A1) und einen zweiten Digital-Analog-Wandler (ISO D/A2), die mit dem Mikroprozessor (µP) verbunden sind, aufweist
und dass der Ausgang des ersten Digital-Analog-Wandlers einen direkten Analogausgang (X) bildet und der Ausgang des zweiten Digital-Analog-Wandlers einen Analogausgang für den Effektivwert (Y) bildet,
ferner mit zwei Relais (R1, R2), die mit dem Mikroprozessor (µP) verbunden sind, dessen Digitalausgänge (W, Z) zum Erkennen der Netzspannung ausgebildet sind.

5. Vorrichtung, nach Patentanspruch 4, **dadurch gekennzeichnet, dass**
die Schnittstelle (FOR) eine Einspeisevorrichtung (ALFOR) aufweist, die mit der Bordbatterie (BT) des Fahrzeuges (1) verbunden ist und Ausgangsspannungen liefert, die voneinander isoliert sind und für die Funktionstüchtigkeit der gesamten Vorrichtung zur Verfügung stehen.

6. Vorrichtung, nach Patentanspruch 5, **dadurch gekennzeichnet, dass**
die Einspeisevorrichtung (ALFOR) mit einem Modulator (MOD) verbunden ist, der seinerseits über die Zuführleitung (12) mit dem Entkopplungstransformator (T) der Messeinheit (POD) verbunden ist.

7. Vorrichtung, nach Patentanspruch 1-6, **dadurch gekennzeichnet, dass**
die Messeinrichtung (POD) in einem Metallgehäuse (10) untergebracht ist, das unter einem Isoliergehäuse angeordnet ist und einen Flansch (13) aufweist, der mit Dichtungen versehen ist und in Ausnehmungen einen Stecker (11) für das optische Fiberkabel (FO) und einen Stecker für die Zuführleitung (12) aufnimmt.

8. Vorrichtung, nach Patentanspruch 7, **dadurch gekennzeichnet, dass**
das Isoliermaterial des Isoliergehäuses aus Silikongummi oder aus Zykloalifatharz besteht.

## Claims

1. Apparatus for measurement of the power supply system voltage in a rail vehicle (1), having a sensor (7) for detection of the voltage, wherein the sensor (7) can be connected to the current pick-up (3) of the rail vehicle, and having an evaluation circuit (6), wherein this evaluation circuit (6) can be connected on one side to the sensor (7) and on the other side to a monitoring device (8) for the electric motor (5) of the rail vehicle (1), **characterized in that**
the apparatus has a measurement device (POD) which holds a voltage divider (R) in the form of a resistance and has a decoupling transformer (T) and **in that** the apparatus also has an interface (FOR),
with the measurement device (POD) and the interface (FOR) being connected to one another via a supply line (12), which is connected to the decoupling transformer (T) and being connected via an optical fibre cable (FO).

2. Apparatus according to Patent Claim 1,
**characterized in that** the measurement device (POD) has an amplifier (AMP) which is connected to the voltage divider (R) that is in the form of a resistance, having a converter (A/D), which indicates the information obtained directly from the voltage divider (R), which is in the form of a resistance, or from the amplifier (AMP) and converts this information to digital form, having a circuit (TEST) which produces the sample voltage of a discharger (SC) which is connected between the voltage divider (R), which is in the form of a resistance, and earth, in order to protect the measurement input, and having an electro-optical transducer (OT) which produces an optical signal at the output, with this optical signal being passed to the fibre cable (FO).

3. Apparatus according to Patent Claim 2,
**characterized in that**
the measurement device (POD) has an internal feed device (ALPOD), which is associated with the interface (FOR) via the decoupling transformer (T) and the supply line which is connected to its output.

4. Apparatus according to Patent Claims 1 to 3,
**characterized in that** the interface (FOR) has an optoelectrical transducer (OR), a microprocessor (µP) which is coupled to the optoelectrical transducer (OR),
a first digital/analogue converter (ISO D/A1) and a second digital/analogue converter (ISO D/A2), which are connected to the microprocessor (µP),
and **in that** the output of the first digital/analogue converter forms a direct analogue output (X), and the output of the second digital/analogue converter forms an analogue output for the root mean square value (Y),
furthermore having two relays (Rl, R2) which are connected to the microprocessor (µP) and whose digital outputs (W, Z) are designed to identify the power supply system voltage.

5. Apparatus according to Patent Claim 4,
**characterized in that**
the interface (FOR) has a feed apparatus (ALFOR) which is connected to the power supply system battery (BT) in the vehicle (1) and produces output voltages which are isolated from one another and are made available for the functionality of the overall apparatus.

6. Apparatus according to Patent Claim 5,
**characterized in that**
the feed apparatus (ALFOR) is connected to a modulator (MOD) which is itself connected to the decoupling transformer (T) of the measurement unit (POD) via the supply line (12).

7. Apparatus according to Patent Claims 1-6,
**characterized in that**
the measurement device (POD) is accommodated in a metal housing (10), which is arranged under an insulating housing and has a flange (13) which is provided with seals, and holds in recesses a plug (11) for the optical fibre cable (FO) and a plug for the supply line (12).

8. Apparatus according to Patent Claim 7,
**characterized in that**
the insulating material of the insulating housing is formed from silicone rubber or from cycloaliphate resin.

## Revendications

1. Dispositif pour mesurer la tension de réseau dans un véhicule ferroviaire (1), comprenant un capteur (7) pour détecter la tension, le capteur (7) pouvant être relié avec le pantographe (3) du véhicule ferroviaire, et comprenant un circuit d'évaluation (6), ce circuit d'évaluation (6) pouvant être relié d'un côté avec le capteur (7) et de l'autre côté avec un dispositif de contrôle (8) du moteur électrique (5) du véhicule ferroviaire (1), **caractérisé en ce que** le dispositif présente un dispositif de mesure (POD), lequel dispositif de mesure (POD) recevant un diviseur de tension (R) réalisée sous la forme d'une résistance et un transformateur de découplage (T), et que le dispositif présente en plus une interface (FOR), le dispositif de mesure (POD) et l'interface (FOR) étant reliés entre eux par le biais d'une ligne d'arrivée (12) qui est reliée au transformateur de découplage (T) et par le biais d'un câble à fibres optiques (FO).

2. Dispositif selon la revendication 1, **caractérisé en ce que** le dispositif de mesure (POD) présente un amplificateur (AMP) qui est relié au diviseur de tension (R) réalisé sous la forme d'une résistance, avec un convertisseur (A/D) qui indique l'information obtenue directement du diviseur de tension (R) réalisé sous la forme d'une résistance ou de l'amplificateur (AMP) et la convertit en forme numérique, avec un circuit de commande (TEST) qui délivre la tension d'essai d'un élément de décharge (SC) qui se trouve entre le diviseur de tension (R) réalisé sous la forme d'une résistance et la masse afin de protéger l'entrée de mesure, et avec un transducteur électro-optique (OT) qui fournit à la sortie un signal optique qui est acheminé au câble à fibres optiques (FO).

3. Dispositif selon la revendication 2, **caractérisé en ce que** le dispositif de mesure (POD) présente un dispositif d'alimentation intérieur (ALPOD) qui est associé à l'interface (FOR) par le biais du transformateur de découplage (T) et de la ligne d'arrivée raccordée à sa sortie.

4. Dispositif selon les revendications 1 à 3, **caractérisé en ce que** l'interface (FOR) présente un transducteur électro-optique (OR), un microprocesseur (µP) qui est relié au transducteur électro-optique (OR), un premier convertisseur numérique/analogique (ISO D/A1) et un deuxième convertisseur numérique/analogique (ISO D/A2) qui sont reliés au microprocesseur (µP) et que la sortie du premier convertisseur numérique/analogique forme une sortie analogique directe (X) et la sortie du deuxième convertisseur numérique/analogique forme une sortie analogique pour la valeur efficace (Y) de plus comprenant deux relais (R1, R2) qui sont reliés avec le microprocesseur dont les sorties numériques (W, Z) sont configurées pour détecter la tension du réseau.

5. Dispositif selon la revendication 4, **caractérisé en ce que** l'interface (FOR) présente un dispositif d'alimentation (ALFOR) qui est relié à la batterie embarquée (BT) du véhicule (1) et délivre des tensions de sortie qui sont isolées les unes des autres et qui sont disponibles pour l'aptitude fonctionnelle de l'ensemble du dispositif.

6. Dispositif selon la revendication 5, **caractérisé en ce que** le dispositif d'alimentation (ALFOR) est relié à un modulateur (MOD) qui est de son côté relié par le biais de la ligne d'arrivée (12) au transformateur de découplage (T) de l'unité de mesure (POD).

7. Dispositif selon les revendications 1 à 6, **caractérisé en ce que** le dispositif de mesure (POD) est logé dans un boîtier métallique (10) qui est disposé sous un boîtier isolant et présente une bride (13) qui est munie de joints et reçoit dans des creux une fiche (11) pour le câble à fibres optiques (FO) et une fiche pour la ligne d'arrivée (12).

8. Dispositif selon la revendication 7, **caractérisé en ce que** le matériau isolant du boîtier isolant se compose de caoutchouc de silicone ou de résine cycloaliphatique.
